# EUROPEAN PATENT APPLICATION

(11) **EP 0 854 203 A1**
(43) Date of publication of application: **22.07.1998**
(21) Application number: 97310651.1
(22) Date of filing: 29.12.1997
(51) Int. Cl.: C23C 14/54

(54) **Substrate coating apparatus**

(30) Priority: 02.01.1997 GB 9700017
(71) Applicant: APPLIED VISION LIMITED, Whitwick, Leicestershire LE67 4JP (GB)
(72) Inventor: White, Norman Henry, * (GB); Waugh, Allan Robert, * (GB); Walls, John Michael, * (GB); Spencer, Alaric Graham, * (GB)
(74) Representative: Wood, Graham

(57) **Abstract**

The invention relates to the provision of apparatus and a method for the application of material or materials onto at least one substrate in a chamber to form a coating thereon, typically by sputter deposition techniques and also if required including reaction producing means. The invention provides for the use of analysis means such as a spectrophotometer in connection with the coating apparatus to allow a representative sample of the coated substrates to be analysed and, if necessary , adjustment made to the control parameters for the apparatus. Another feature is the analysis of previously coated substrates and the setting of control parameters for the apparatus to deposit equivalent coatings on subsequent substrates.

## Description

The invention which is the subject of this application relates to apparatus for applying coatings of a single layer or multilayers of material onto surfaces of substrates such as, but not exclusively, optical lenses. The invention is particularly suited to the application of said material onto the substrates by the sputtering of the material from targets of the said material and, if required, providing a reaction zone in the sputtering apparatus through which the coated substrates pass to cause a desired reaction of the sputtered material.

There are several different known methods and apparatus for applying relatively thin coatings of materials onto substrates and one known problem is the measuring of the quality of the coating and the depth of the same once applied. In some types of apparatus, such as in evaporation coating apparatus, the measurement of the coatings is required to be performed by quartz crystal monitors which act to control the coating operation as it progresses and which, when a certain thickness of a particular material is achieved, trigger a change to a different type of coating material. This type of monitoring and control is required due to the nature of evaporation coating but the apparatus is expensive and is not required when the material is applied to the substrates by sputter deposition s the amount of material which is sputtered is related to the time of operation at constant power and is therefore more predictable. However it has been found that the performance of the sputter deposition apparatus "drifts" from the required parameters after a period of use and hence the substrates which are coated can be of inferior quality. This is due to the fact that the target performance will drift and so the quality and structure of the coating will change.

At the present time, manual checks are undertaken of sample substrates after a specific quantity have been produced and the parameters of the apparatus can be reset, but this is not a satisfactory solution as the apparatus is frequently installed in places where no skilled operators or suitable checking apparatus is provided, such as opticians shops. Thus the substrates are checked by non-skilled persons and errors in the measurements taken can occur or the substrates are sent for checking and this causes delays in receiving the results and hence the apparatus may be operating on incorrect control settings in the delay.

The aim of the present invention is to provide apparatus for applying material to at least one, but typically a plurality, of substrates and to provide the apparatus with a means for checking at least samples of said substrates and to allow control of the parameters of operation of the apparatus accordingly.

In a first aspect of the invention there is provided apparatus for the application of material onto at least one substrate to apply a coating thereon, said apparatus including a vacuum chamber in which said substrate is placed for coating, at least one material source and a means for causing said at least one material to be applied to the substrate to form a coating thereon and wherein said apparatus further includes or is connected to analysis means to allow at least one property of the coating which is applied to the substrate to be analysed.

Typically the apparatus includes two or more material sources and the coating which is applied is a multilayered multimaterial coating.

In a particular embodiment the apparatus is provided for the sputter deposition of material from a plurality of material sources of different materials to form the coating and comprises a vacuum chamber in which the substrates to be coated are held for rotation on a holder, at least one target of a material mounted as part of a magnetron to sputter said material onto said substrates and a reaction producing means to react said sputtered material and said apparatus further includes a spectrophotometer to allow the optical quality of the coating applied to the substrate to be checked.

In one embodiment the reaction producing means defines a reaction zone within the vacuum chamber. The reactions which can be produced are for example the formation of the deposited material on the substrates into oxides nitrides and the like by the introduction of appropriate gases into the chamber in the appropriate locations.

The substrates can be held on linear, or in-line moving holders, rather than rotational holders.

In one embodiment the analysis results are automatically sent to the control system for the apparatus and compared with standard coating values. If the comparison indicates a significant difference the control system parameters for operation of the apparatus can be altered manually or automatically. In one embodiment three key result values are analysed. In an alternative embodiment all of the result values are analysed.

In a preferred embodiment the spectrophotometer is provided as an integral part of the apparatus control system which includes in a memory the required optical quality values for specific types of coatings and for which values the spectrophotometer analyses applied coatings and the readings obtained from the spectrophotometer are compared against the appropriate values held in the memory. If the readings are within the pre-set limit values, the control parameters of the apparatus are not changed but if the readings fall outwith the pre-set limit values the control parameters are adjusted, to alter the appropriate parameter values..

In one embodiment, if adjustment of the control parameters is required this will be indicated to the operator of the apparatus on site along with the required value changes whereupon the operator can then make the changes or, preferably, the control parameters are altered automatically within the apparatus control system. Typically the control system includes a software program which causes the control parameters to be adjusted according to the particular measurement or measurements which are found to fall outwith the pre-set limit values. Typically the adjustment in the control parameter is an adjustment of the time of operation of the material source or each of the sources.

In a further aspect of the invention there is provided a method for checking the quality of a coating on a substrate, said method including the steps of placing the at least one substrate into a coating chamber, operating the apparatus to cause a coating of specific characteristic to be applied thereto, removing the substrate from the chamber and placing the same in a spectrophotometer provided as part of or connected to the apparatus, wherein said spectrophotometer measures the coating and compares the readings against preset limit values and, if the readings fall outwith the limit values, an appropriate signal is indicated to the operator or sent to the control system of the apparatus to adjust and/or indicate required adjustments to the appropriate control parameters for subsequent operation of the coating process.

It is envisaged that a representative and statistically significant sample of the substrates which are coated are tested in the spectrophotometer although, if required, testing of all of the substrates can be performed.

In a further aspect of the invention there is provided apparatus for the application of a coating by depositing material onto a substrate, said apparatus comprising a vacuum chamber in which said substrates are coated and in which is provided a material for sputter deposition onto the substrates and a reaction producing means to react the sputtered material as required and wherein said apparatus includes a spectrophotometer for analysis of the coating applied and connected to the control system for control of the sputtering apparatus and adjustment of the control system parameters responsive to the analysis results.

Typically the spectrophotometer is connected to the control system of the apparatus.

Typically the sputtering of material is created by sputtering a material target in a magnetron and the reaction producing means is operated to create a reaction zone in the chamber.

Ina further aspect of the invention there is provided apparatus for applying a coating of material onto a substrate, said apparatus including a vacuum chamber in which said substrate is coated and at least one material source from which material is applied to said substrate and characterised in that said apparatus includes a spectrophotometer for analysis of said coatings and is connected to the control system of the apparatus so that the results of an analysis of a precoated reference substrate are sent to the control system of the apparatus and processed to generate a set of control parameters for operation of the apparatus to apply a coating to subsequent substrates equivalent to that of the reference substrate.

Thus there is provided apparatus for the application of a coating onto a substrate by sputter deposition from a material source, said apparatus including a spectrophotometer and wherein a coated substrate is analysed by the spectrophotometer, the results input into the apparatus control system and an operating sequence generated for subsequent operation of the apparatus to apply a coating similar to that analysed onto the subsequent substrate.

In a further aspect there is provided a method for applying a coating with designated characteristics onto a substrate by applying said coating using apparatus for depositing material from one or a plurality of material sources connected with a spectrophotometer, said method including the steps of placing a substrate with a previously applied coating of the required characteristics to act as a reference coating for analysis by the spectrophotometer, obtaining a set of values related to said coating, sending said values to the control system for the coating apparatus, processing said values to generate a set of control parameters for the apparatus to apply a coating to subsequent substrates with the characteristics of the said reference coating and operating said apparatus with said control parameters to apply the required coating.

Thus for one method of operation the substrates to be coated are optical lens, and a lens which is already coated, and not necessarily by the apparatus to which the spectrophotometer is connected, is placed for measurement by the spectrophotometer and wherein the readings obtained from said measurement are analysed by the apparatus control system and a set of control parameters generated which, when used to control the operation of the sputter deposition and reaction means for applying coatings on the substrates in the apparatus, create a coating which has substantially the same characteristics as that which was initially measured.

Specific embodiments of the invention are now described with reference to the accompanying drawings wherein:-
Figure 1 illustrates one embodiment of material deposition apparatus;
Figure 2 illustrates in a schematic fashion a method according to one aspect of the invention;
Figure 3 illustrates in a schematic fashion a method according to a second aspect of the invention;
Figure 4 illustrates one scan graph obtained by spectrophotometer analysis of a sputter coated substrate, and
Figures 5 - 8 indicate one embodiment of a sequence of analyses followed by an operator.

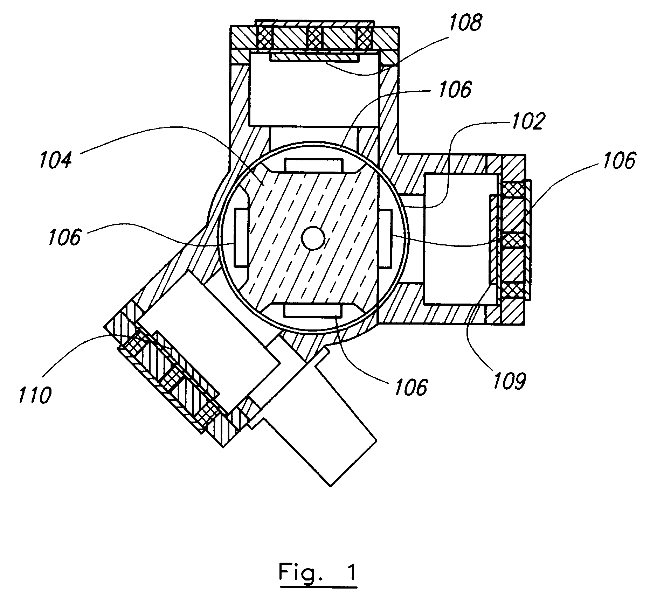

Material deposition apparatus of the type to which this invention relates is used to apply relatively thin layers, measured in atomic layers, as a coating to substrates such as optical lenses, light bulbs and the like to produce a required effect such as, for example, to form an anti-reflective coating. The apparatus comprises, in one known embodiment and as shown in Figure 1, a vacuum chamber 102 which contains a holder 104 for rotation and on which are placed a plurality of substrates 106 to be coated. Also contained within the chamber are first and second material sources which in this case are magnetrons 108, 109 each including a target of a material, such as a metal, for example, which is to be applied as a coating by sputter deposition. In this embodiment a reaction producing means 110 such as an ion source or plasma source is provided which is used to create a reaction zone through which the substrates pass as the holder rotates, a gas source is provided for introducing a suitable gas into suitable areas of the chamber so that the reaction producing means reacts the sputter material on the substrate to form a required composition. The operation of the sputter magnetrons 108,109 is controlled to create coatings of the required thickness and multi-layered multi-material composition and, as the operation of the same can be sufficiently predictable in certain apparatus, the thickness of a layer of applied material can be determined by the time of operation of the appropriate magnetron and repeated with the appropriate magnetrons' operated until the desired coating is built. However, when the apparatus is used over a longer time period of, for example, a week, the control parameters of the same tend to drift from the required values and it has been found that the quality of the coating achieved can lie outwith the required limits.

It should be noted that the above apparatus described is only one example of apparatus according to the invention and should not be regarded as limiting the scope of the invention.

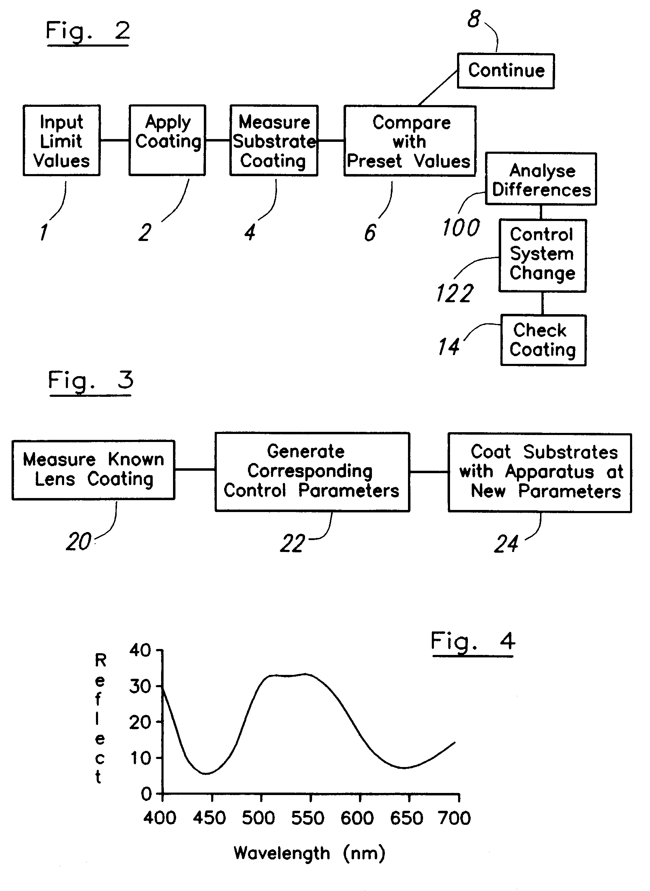

Thus the present invention provides apparatus and a method whereby the control parameters of the apparatus, such as for example, time of operation, can be adjusted, if required, at regular intervals in response to the measurement of the quality of at least one substrate which has been coated in said apparatus and a schematic illustration of the method is shown in Figure 2. Figure 2 illustrates the first stage 1 of the invention which is the introduction of pre-set limit values in to the spectrophotometer memory which relate to a specific type of coating which is to be applied by the apparatus to a series of substrates. The next stage 2 is to apply the coating to the substrates and after a period of production remove a sample number of coated substrates and measure the same 4 by the spectrophotometer. The readings obtained from the spectrophotometer are then compared 6 with the pre-set limit values for that specific coating. If the readings are within the present values then no action 8 is taken and the apparatus continues as before but if the readings are outwith the pre-set values the same are analysed 10 to identify and select the cause of the problem according to preprogrammed information and an appropriate signal sent to the control system 12 for the apparatus to adjust the control parameters and/or perform another operation, such as cleaning, to bring the quality of the coating within the pre-set limit values. Subsequently lens are then checked 14 and if the fault has persisted an alert signal can be sent to the apparatus operator.

Figure 3 illustrates a further aspect of the invention using similar apparatus to that described previously and said aspect may be utilised in conjunction with the checking method of Figure 2. In this aspect a lens which has already been coated and which may be a commercially available lens, is used a reference and measured 20 by the spectrophotometer of the apparatus. The readings from the measurement are then processed and, using preprogrammed data, a set of control parameters 22 are created for the apparatus. Substrates are then placed in to the apparatus for coating and the apparatus operated 24 according to the control parameters 22 to apply a coating on the substrates which has the same optical characteristics as the reference coating on the substrate measured at stage 20.

Thus the apparatus of the invention can be used to mimic and recreate the coatings which have been applied to other lens and can be used to check coatings with regard to existing limits on-site and can adjust the parameters accordingly on-site thereby overcoming the problems and time delays of conventional apparatus.

Figure 4 illustrates a scan graph result using one type of spectrophotometer which can be incorporated into the invention. The scan was obtained by analysing a sputter coated optical lens.

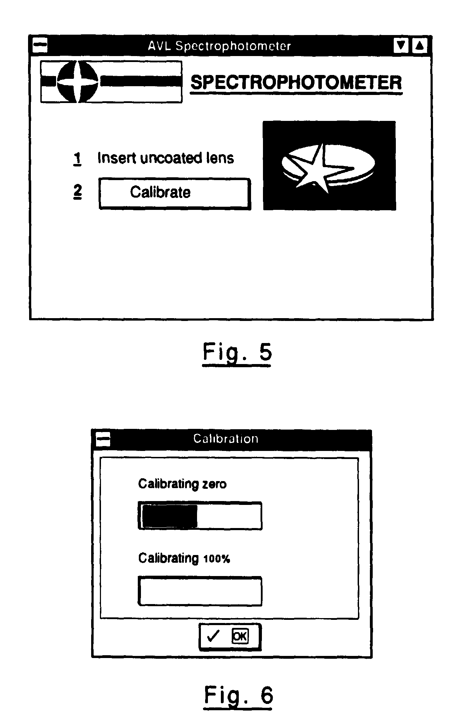

Figures 5 - 8 illustrate one procedure of the invention followed by an operator of the apparatus. Figure 5 illustrates a first display that indicates to the user of the apparatus that a first uncoated lens is to be inserted for analysis by the spectrophotometer. This is used to calibrate the spectrophotometer as indicated in Fig. 6 so that the spectrophotometer then measures zero (lamp off or shielded). The lamp is then turned on (or the shielding removed) and the spectrophotometer measures 100%. Each measurement can take, for example, about 1 second. Graphics on the display indicate to the operator that the calibration is occurring. The operator is then returned to the first display of Figure 5 at which stage a coated lens can be introduced for analysis.

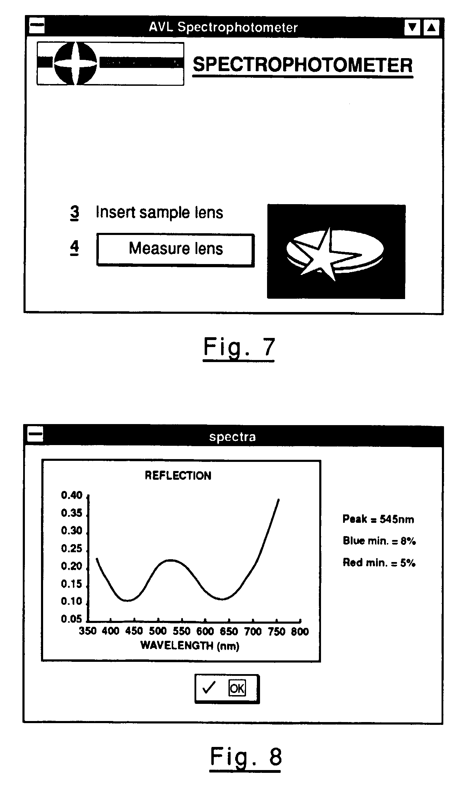

Figures 7 and 8 illustrate the display for measuring the coating on the sample lens and the scan obtained. The scan results are analysed and, in this instance, three key results obtained and displayed which are Peak, Blue minimum and Red minimum. These results can then be considered by the operator and/or automatically analysed and any adjustments to the operating parameters, such as time of operation of the sputter apparatus made, to bring the coatings applied within acceptable values.

Thus there is provided apparatus which allows the analysis of coatings applied by sputter deposition techniques to be analysed in situ by an operator of the apparatus. Alternatively the invention allows for the automatic analysis and alteration of control parameters by allowing the substrates to be analysed to be placed automatically in position for analysis by the spectrophotometer and/or for the substrates to be moved past the spectrophotometer and the same controlled to be selectively operable to analyse a sample quantity of the substrates which move past the same.

## Claims

1. Apparatus for the application of material onto at least one substrate to apply a coating thereon, said apparatus including a vacuum chamber in which said at least one substrate is placed for coating, at least one material source and a means for causing said at least one material to be applied to the substrate to form a coating thereon and characterised in that said apparatus further includes or is connected to analysis means to allow at least one property of the coating which is applied to the substrate to be analysed.

2. Apparatus according to claim 1 characterised in that the analysis means is a spectrophotometer connected to the control system for the apparatus to allow results obtained from the analysis by spectrophotometer to be sent to and processed by the apparatus control system for calibration of the control system and, if necessary, the control parameters adjusted.

3. Apparatus according to claim 2 characterised in that the apparatus control system includes in a memory the required optical limit values for specific coatings and against which the readings obtained from the spectrophotometer are compared and, if the readings are within the pre-set limit values, the control parameters of the apparatus are not changed but if the readings fall outwith the pre-set limit values this is indicated.

4. Apparatus according to claim 3 characterised in that if the readings fall outwith the limit values the control system automatically adjusts the operating parameters of the apparatus accordingly.

5. Apparatus according to claim 3 characterised in that if the readings fall outwith the limit values this is indicated via a display to the operator of the apparatus who can then adjust the control parameters accordingly.

6. Apparatus according to claim 5 characterised in that the required parameter changes are indicated to the operator of the apparatus.

7. Apparatus according to claim 1 characterised in that the apparatus includes two or more material sources and the coating which is applied is a multi-layered multi-material coating.

8. Apparatus according to claim 1 characterised in that the material is applied to the at least one substrate by sputter deposition of material from the material sources to form the coating.

9. Apparatus according to claim 1 characterised in that the apparatus includes the at least one substrate held in the vacuum chamber for rotation on a holder, at least one target of a material mounted as part of a magnetron to sputter said material onto said substrates and a reaction producing means to react said sputtered material and said apparatus further includes a spectrophotometer to allow the optical quality of the coating applied to the substrate to be analysed.

10. Apparatus according to claim 9 characterised in that the reaction producing means is an ion source or plasma source.

11. Apparatus according to claim 9 characterised in that the at least one substrate is provided for movement in-line rather than by rotation.

12. Apparatus for the application of a coating by sputter depositing material onto a plurality of substrates, said apparatus comprising a vacuum chamber in which said substrates are coated and in which is provided a material for sputter deposition onto the substrates and a reaction producing means to create a reaction zone to react the sputtered material and characterised in that said apparatus includes a spectrophotometer for analysis of the coating applied and connected to the control system for control of the apparatus and adjustment of the control system parameters responsive to the analysis results.

13. A method for applying a coating to at least one substrate and checking the quality of the same, said method including the steps of placing the at least one substrate into a coating chamber, operating the apparatus to cause a coating of specified characteristic to be applied thereto, placing the substrate in the location of a spectrophotometer connected to the coating apparatus, analysing the coating using the spectrophotometer and characterised by comparing the analysis readings against preset limit values for the coating and, if the readings fall outwith the limit values, an appropriate signal is displayed to the operator or sent to the control system of the apparatus to adjust the appropriate control parameters for subsequent operation of the coating apparatus.

14. A method according to claim 13 characterised in that a plurality of substrates are coated and a representative and significant sample of the substrates which are coated are analysed by the spectrophotometer.

15. A method according to claim 13 characterised in that the material is deposited onto the substrates by sputter deposition.

16. A method according to claim 15 characterised in that the deposited material is exposed to a reaction producing means during the coating process.

17. A method according to claim 16 characterised in that the reaction producing means defines a reaction zone within the coating chamber.

18. Apparatus for applying a coating of material onto a substrate, said apparatus including a vacuum chamber in which said substrate is coated and at least one material source from which material is sputtered to be applied to said substrate and characterised in that said apparatus includes a spectrophotometer for analysis of said substrate coating and is connected to the control system of the apparatus to allow the results of an analysis of a precoated substrate to be sent to the control system of the apparatus and processed to generate a set of control parameters for operation of the apparatus to apply an equivalent coating to that of the precoated substrate to subsequent substrates.

19. Apparatus according to claim 18 characterised in that there is a plurality of material sources, the operation of which during a coating process is determined by the control parameters for the operation of the apparatus.

20. Apparatus according to claim 18 characterised in that apparatus includes a reaction producing means.

21. A method for applying a coating with designated characteristics onto a substrate by applying said coating using apparatus for depositing material from one or a plurality of material sources connected with a spectrophotometer, said method including the steps of placing a substrate with a previously applied coating of the required characteristics to act as a reference coating for analysis by the spectrophotometer, obtaining a set of values related to said coating, sending said values to the control system for the coating apparatus, processing said values to generate a set of control parameters for the apparatus to apply a coating to subsequent substrates with the characteristics of the said reference coating and operating said apparatus with said control parameters to apply the required coating.

22. A method according to claim 21 characterised in that representative samples of the subsequently coated substrates are analysed using the spectrophotometer and the characteristics compared against those of the reference coating.

23. A method according to claim 21 characterised in that the apparatus includes a reaction producing means which operation is also defined by the control parameters set for the apparatus.
